# EUROPÄISCHE PATENTANMELDUNG

(11) **EP 1 101 836 A1**
(43) Veröffentlichungstag der Anmeldung: **23.05.2001**
(21) Anmeldenummer: 00121652.2
(22) Anmeldetag: 04.10.2000
(51) Int. Cl.: C23C 14/50

(54) **Vacuum-Beschichtungsanlage zum Aufbringen von Vergütungsschichten auf optische Substrate**

(30) Priorität: 22.11.1999 CH 214499
(71) Anmelder: Satis Vacuum Industries Vertriebs - AG, 6341 Baar (CH)
(72) Erfinder: Siegrist, Beat, 8704 Herrliberg (CH)
(74) Vertreter: Petschner, Goetz

(57) **Zusammenfassung**

Die Vakuum-Beschichtungsanlage dient dem Aufbringen von Vergütungsschichten auf Flächen optischer Substrate (10), wie Brillengläser, welche auf einer Trägervorrichtung (3,3') aufspannbar sind. Letztere ist in einem gasdicht verschliessbaren, evakuierbaren und mit einer Atmosphäre aus inertem Gas versehbaren Rezipienten (1) mit mindestens einer Beschichtungsquelle (4), insbesondere Magnetron-Sputtering-Target, drehbar angeordnet. Hierbei sind die Aufspannmittel (10') für jeweils ein Substrat (10) je über eine Achse (5) an der Trägervorrichtung (3,3') angeordnet und über Getriebemittel (6) mit dieser drehverbunden. Weiter ist die Rotationwelle (3') der Trägervorrichtung (3,3') exzentrisch zur Zentrumsaxe (4") des ortsfesten Sputter-Target (4') der Magnetron-Sputtering-Beschichtungsquelle (4) angeordnet und weiter die Ebene jedes Aufspannmittels (10') nach innen geneigt ist, wobei deren verlängerte Drehachsen (5) mit der verlängerten Axe (3") der Rotationswelle (3') in Richtung Beschichtungsquelle (4) einen spitzen Winkel einschliessen.

Durch diese Massnahmen ist es nunmehr möglich, dass die zu beschichtenden Substratflächen immer in genau definierter Position wie Bewegung zur Verteilungscharakteristik des vom Target abgetragenen Beschichtungsmaterials stehen, um auf jeder Fläche einen optimalen, gleichförmigen Niederschlag zu erreichen.

## Beschreibung

Die vorliegende Erfindung betrifft eine Vakuum-Beschichtungsanlage zum Aufbringen von Vergütungsschichten auf Flächen optischer Substrate, wie Brillengläser, welche auf einer Trägervorrichtung aufspannbar sind, die in einem gasdicht verschliessbaren, evakuierbaren und mit einer Atmosphäre aus inertem Gas, wie Argon oder Krypton oder auch Sauerstoff oder Stickstoff, versehbaren Rezipienten mit mindestens einer Beschichtungsquelle, insbesondere Magnetron-Sputtering-Target, drehbar angeordnet ist.

Es hat sich gezeigt, dass insbesondere die Sputtering-Beschichtungstechnik primär für die Belegung planer Oberflächen, beispielsweise Si-Wafer, Flachgläser u.a. geeignet ist, um hier eine optimale und möglichst absolut gleichförmige Beschichtung der gesamten Substrat-Fläche zu erreichen.

Bei einer solchen Beschichtungstechnik auch von optischen Substraten, wie Brillengläser, Linsen u.a. konnte ein solches optimales Ergebnis allerdings bisher nicht erreicht werden, da einerseits die zu bedampfenden Substratoberflächen eine genau definierte Position wie Bewegung zu der sich im Rezipienten einstellenden geometrischen Verteilung des vom Target abgetragenen Beschichtungsmaterials einnehmen müssen, um auf jeder Fläche einen optimalen, gleichförmigen Niederschlag zu erreichen, dort andrerseits entgegensteht, dass Brillengläser mit unterschiedlichsten geometrischen Formen, etwa bezüglich Linsendurchmesser und Linsendicke sowie stark voneinander abweichende Krümmungsradien der Oberflächen u.a. Verwendung finden.

Eine homogene Beschichtung, also eine konstante Schichtdicke über die gesamten gekrümmten Linsenflächen ist aber schon deshalb wichtig, weil Abweichungen in der Schichtdicke von bereits wenigen Nanometern, also wenigen Atomschichten, visuell als störende Farbänderungen leicht erkennbar sind.

Es ist deshalb Aufgabe der vorliegenden Erfindung, eine Vakuum-Beschichtungsanlage zum Aufbringen von Vergütungsschichten auf Flächen optischer Substrate, wie Brillengläser, der vorgenannten Art so auszugestalten, dass hier in sehr einfacher Weise die zu beschichtenden Substratflächen immer in genau definierter Position wie Bewegung zur Verteilungscharakteristik des vom Target abgetragenen Beschichtungsmaterials stehen, um auf jeder Fläche einen optimalen, gleichförmigen Niederschlag zu erreichen.

Dies wird erfindungsgemäss zunächst dadurch erreicht, dass die Aufspannmittel für jeweils ein Substrat je über eine Achse an der Trägervorrichtung angeordnet und über Getriebemittel mit dieser drehverbunden sind.

Hierbei ist es vorteilhaft, wenn die Drehzahl der Aufspannmittel für die Substrate grösser, vorzugsweise ein Mehrfaches der Drehzahl der Trägervorrichtung ist.

Ferner ist es erfindungswesentlich, wenn die Rotationswelle der Trägervorrichtung exzentrisch zur Zentrumsaxe des ortsfesten Sputter-Target der Magnetron-Sputtering-Beschichtungsquelle angeordnet ist und wenn die Ebene jedes Aufspannmittels nach innen geneigt ist, wobei deren verlängerte Drehachsen mit der verlängerten Axe der Rotationswelle in Richtung Beschichtungsquelle einen spitzen Winkel einschliessen.

Durch diese Massnahmen, nämlich das Umlaufen der auf die selbst umlaufende Trägervorrichtung angeordneten Substrate mit vorzugsweise höherer Drehzahl in Gleichrichtung oder Gegenrichtung, die Exzentrizität der umlaufenden Trägervorrichtung zur Zentrumsaxe des ortsfesten Sputter-Target der Magnetron-Sputtering-Beschichtungsquelle sowie die erreichte Neigung der Substrate durch die Neigung der Achsen der Aufspannmittel nach innen in Richtung Beschichtungsquelle, ist es möglich, die die zu beschichtenden Substratflächen immer in genau definierter Position wie Bewegung zur Verteilungscharakteristik des vom Target abgetragenen Beschichtungsmaterials zu halten, um auf jeder Fläche einen optimalen, gleichförmigen Niederschlag zu erreichen.

Ferner ergibt sich eine vorteilhafte Ausgestaltung der erfindungsgemässen Anordnung dadurch, wenn die Getriebemittel ein motorisch antreibbares Planetengetriebe umfassen, wobei mit jedem Aufspannmittel für ein Substrat ein Planetenrad drehfest verbunden ist.

Eine beispielsweise Ausführungsform des Erfindungsgegenstandes ist nachfolgend anhand der Zeichnung näher erläutert. Es zeigen:

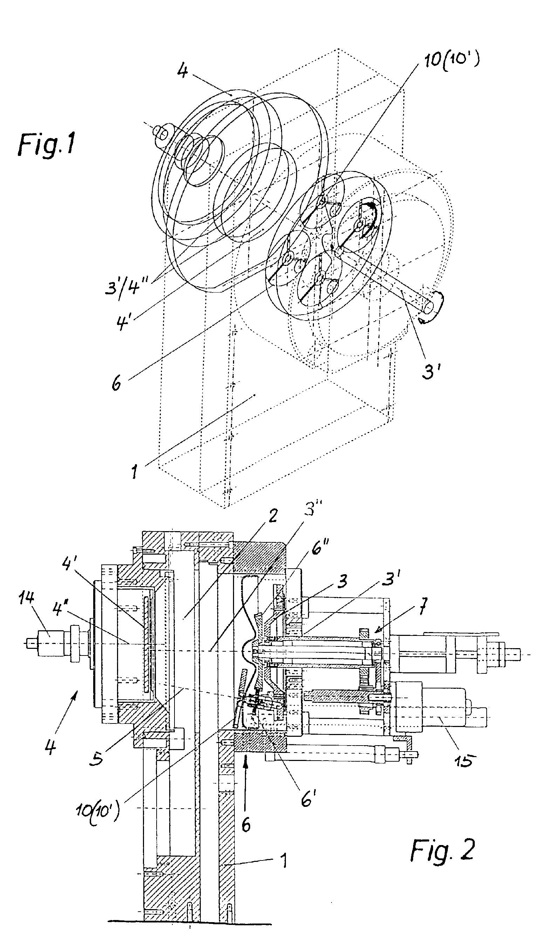

- Fig. 1: in schematischer, schaubildartiger Darstellung die erfindungsgemässe Vakuum-Beschichtungsanlage zum Aufbringen von Vergütungsschichten auf Flächen optischer Substrate,
und
- Fig. 2: im Querschnitt in schematischer Darstellung die erfindungsgemässe Vakuum-Beschichtungsanlage gemäss Fig. 1.

Die beispielsweise veranschaulichte Vakuum-Beschichtungsanlage zum Aufbringen von Vergütungsschichten auf optische Substrate, beispielsweise hier Kunststoff-Brillenglaser 10, umfasst einen, über nicht näher veranschaulichte Vakuum-Pumpenmittel evakuierbaren Rezipienten 1.

Im, bei dieser beispielsweisen Anordnung, oberen erweiterten Kammerbereich 2 dieses gasdicht verschliessbaren, evakuierbaren und mit einer Atmosphäre aus inertem Gas, wie Argon oder Krypton oder Sauerstoff oder Stickstoff, versehbaren Rezipienten 1 befindet sich eine auswechselbare Verdampfungsquelle 4, insbesondere Magnetron-Sputtering-Beschichtungsquelle, der gegenüber und im Wirkungsbereich des zentrisch der Magnetron-Sputtering-Beschichtungsquelle abgestäubten Beschichtungsmaterials eine Trägervorrichtung 3,3' mit Aufspannmitteln 10' für die zu beschichtenden optischen Substrate 10 drehbar angeordnet ist.

Eine solche Vakuum-Beschichtungsanlage ist ansich bekannt und beliebig in der räumlichen Anordnung.

Ebenso bekannt ist die hier verwendete Magnetron-Sputtering-Beschichtungsquelle 4 mit dem Sputter-Target oder -Tiegel 4', sodass sich hier eine nähere Beschreibung erübrigt.

Zur Lösung der Aufgabe, nunmehr die zu bedampfenden Substratflächen immer in genau definierter Position wie Bewegung zur Verteilungscharakteristik des vom Target abgetragenen Beschichtungsmaterials zu halten, um auf jeder Fläche einen optimalen, gleichförmigen Niederschlag zu erreichen. ist zunächt erfindungswesentlich, dass die Aufspannmittel 10' für jeweils ein Substrat 10 je über eine Achse 5 an der Trägervorrichtung 3,3' angeordnet und über Getriebemittel 6 mit dieser drehverbunden sind.

Diese Getriebemittel 6 umfassen ein motorisch antreibbares Planetengetriebe 6',6", wobei mit jedem Aufspannmittel 10' für ein Substrat 10 ein Planetenrad 6' drehfest verbunden ist.

Diese, hier beispielsweise 4 Planetenräder 6' greifen dabei in einen feststehenden Zahnkranz 6" ein und drehen an diesem beim Umlauf des Drehtisches 3 der Trägervorrichtung, wobei die Drehzahl der Aufspannmittel 10' für die Substrate 10 grösser, vorzugsweise ein Mehrfaches der Drehzahl der Trägervorrichtung 3,3' ist.

Der Antrieb des Drehtisches 3 erfolgt dabei über ein an einer Hohlwelle 3' der Trägervorrichtung angreifendes, mit einem Motor 15 verbundenen Getriebe 7.

Hierbei ist weiter erfindungswesentlich, dass die Rotationwelle 3' der Trägervorrichtung 3,3' exzentrisch zur Zentrumsaxe 4" des statischen Sputter-Target 4' der Magnetron-Sputtering-Beschichtungsquelle 4 angeordnet ist.

Weiter ist erfindungswesentlich, dass die Ebene jedes Aufspannmittels 10' nach innen geneigt ist, wobei deren verlängerte Drehachsen 5 mit der verlängerten Axe 3" der Rotationswelle 3' in Richtung Beschichtungsquelle 4 einen spitzen Winkel einschliessen.

Durch diese Neigung der Substrate infolge der Neigung der Ebene der Auffspannmittel in Richtung der Magnetron-Sputtering-Beschichtungsquelle, ferner das Umlaufen der auf die selbst umlaufende Trägervorrichtung angeordneten Substrate mit vorzugsweise höherer Drehzahl in Gleichrichtung oder Gegenrichtung, sowie die Exzentrizität der umlaufenden Trägervorrichtung zur Zentrumsaxe des ortsfesten Sputter-Target der Magnetron-Sputtering-Beschichtungsquelle ist es nunmehr möglich, die zu bedampfenden Substratflächen immer in genau definierter Position wie Bewegung zur Verteilungscharakteristik des vom Target abgetragenen Beschichtungsmaterials zu halten, um auf jeder Fläche einen optimalen, gleichförmigen Niederschlag zu erreichen.

Es wird Schutz beansprucht wie folgt:

## Patentansprüche

1. Vakuum-Beschichtungsanlage zum Aufbringen von Vergütungsschichten auf Flächen optischer Substrate (10), wie Brillengläser, welche auf einer Trägervorrichtung (3,3') aufspannbar sind, die in einem gasdicht verschliessbaren, evakuierbaren und mit einer Atmosphäre aus inertem Gas versehbaren Rezipienten (1) mit mindestens einer Beschichtungsquelle (4), insbesondere Magnetron-Sputtering-Target, drehbar angeordnet ist, dadurch gekennzeichnet,
dass die Aufspannmittel (10') für jeweils ein Substrat (10) je über eine Achse (5) an der Trägervorrichtung (3,3') angeordnet und über Getriebemittel (6) mit dieser drehverbunden sind.

2. Vakuum-Beschichtungsanlage nach Anspruch 1, dadurch gekennzeichnet, dass die Getriebemittel (6) ein motorisch antreibbares Planetengetriebe (6',6") umfassen, wobei mit jedem Aufspannmittel (10') für ein Substrat (10) ein Planetenrad (6') drehfest verbunden ist.

3. Vakuum-Beschichtungsanlage nach Anspruch 1 oder 2, dadurch gekennzeichnet, dass die Drehzahl der Aufspannmittel (10') für die Substrate (10) grösser, vorzugsweise ein Mehrfaches der Drehzahl der Trägervorrichtung (3,3') ist.

4. Vakuum-Beschichtungsanlage nach Anspruch 1, dadurch gekennzeichnet, dass die Rotationwelle (3') der Trägervorrichtung (3,3') exzentrisch zur Zentrumsaxe (4") des statischen Sputter-Target (4') der Magnetron-Sputtering-Beschichtungsquelle (4) angeordnet ist.

5. Vakuum-Beschichtungsanlage nach Anspruch 1, dadurch gekennzeichnet, dass die Ebene jedes Aufspannmittels (10') nach innen geneigt ist, wobei deren verlängerte Drehachsen (5) mit der verlängerten Axe (3") der Rotationswelle (3') in Richtung Beschichtungsquelle (4) einen spitzen Winkel einschliessen.
